# DEMANDE DE BREVET EUROPEEN

(11) **EP 1 978 547 A1**
(43) Date de publication de la demande: **08.10.2008**
(21) Numéro de dépôt: 08103299.7
(22) Date de dépôt: 01.04.2008
(51) Int. Cl.: H01L 21/20

(54) **Procédé de fabrication d'un dispositif à gradient de concentration et dispositif correspondant**

(30) Priorité: 03.04.2007 FR 0754226
(71) Demandeur: STMICROELECTRONICS SA, 92120 Montrouge (FR); STMicroelectronics (Crolles 2) SAS, 38920 Crolles (FR)
(72) Inventeur: Bensahel, Daniel-Camille, 38000 Grenoble (FR); Morand, Yves, 38000 Grenoble (FR)
(74) Mandataire: Zapalowicz, Francis

(57) **Abrégé**

Procédé de fabrication d'un dispositif semiconducteur, comprenant la formation au sein d'un substrat semiconducteur (1) d'au moins une région continue (4) formée d'un matériau présentant une composition non uniforme dans une direction sensiblement perpendiculaire à l'épaisseur du substrat (1).

## Description

L'invention concerne la microélectronique.

La microélectronique est classiquement basée sur la réalisation de dispositifs planaires.

En utilisant les seules techniques de dépôt, on peut déposer des couches successives de matériaux conformes, dans lesquelles la composition chimique varie d'une couche à la suivante. On obtient ainsi un gradient vertical si les variations de composition d'une couche à la suivante sont assez faibles.

Le dopage permet également de faire varier la composition de façon graduelle à l'intérieur d'une couche délimitée par des interfaces.

Toutes ces techniques classiques induisent la création d'un gradient vertical de composition, c'est-à-dire parallèlement à l'épaisseur du substrat, bien adapté aux procédés de fabrication classiques.

Selon un mode de réalisation, il est proposé une structure dissymétrique dans le plan et non plus en épaisseur. Un exemple d'application non limitatif est une gravure en pente ou encore une compensation des difficultés de gravure.

Selon un aspect, il est proposé un procédé de fabrication d'un dispositif semiconducteur, comprenant la formation au sein d'un substrat semiconducteur d'au moins une région continue formée d'un matériau présentant une composition non uniforme dans une direction sensiblement perpendiculaire à l'épaisseur du substrat.

Ladite région continue peut être formée d'un matériau présentant une variation graduelle de composition le long de ladite direction.

La formation de la région continue peut comprendre par exemple la formation de zones d'un alliage semi-conducteur ayant des compositions différentes dans une direction sensiblement perpendiculaire à l'épaisseur du substrat.

La formation desdites zones d'alliage peut comprendre par exemple la formation de couches successives dudit alliage s'étendant toutes au moins partiellement dans une direction sensiblement parallèle à l'épaisseur du substrat et présentant respectivement des compositions différentes dudit alliage.

Les compositions différentes desdites couches peuvent former un gradient de concentrations de l'un des composants dudit alliage.

Ledit alliage peut comprendre du silicium et du germanium.

Selon un mode de mise en oeuvre, la formation de la région semiconductrice continue peut comprendre la formation d'une cavité dans le substrat et la formation au moins sur les parois verticales de la cavité d'un empilement de couches dudit alliage présentant respectivement des compositions différentes dudit alliage.

Selon un autre mode de mise en oeuvre, le substrat peut être formé d'un des composants dudit alliage et la formation de la région semiconductrice continue peut comprendre la formation d'une cavité dans le substrat, le remplissage de la cavité par ledit alliage et un recuit de diffusion de façon à former dans une partie du substrat adjacente à ladite cavité, des couches successives dudit alliage s'étendant toutes dans une direction sensiblement parallèle à l'épaisseur du substrat et présentant respectivement des compositions différentes dudit alliage.

Selon un mode de mise en oeuvre, un procédé peut comprendre en outre une gravure de la surface supérieure de ladite région continue, ladite gravure ayant des caractéristiques différentes en fonction de ladite composition.

Selon un autre aspect, il est proposé un dispositif semiconducteur comprenant au sein d'un substrat semiconducteur au moins une région continue formée d'un matériau présentant une composition non uniforme dans une direction sensiblement perpendiculaire à l'épaisseur du substrat.

Ladite région continue peut être formée d'un matériau présentant une variation graduelle de composition le long de ladite direction.

Selon un mode de réalisation, la région semiconductrice continue peut comprendre un alliage semi-conducteur ayant des zones de compositions différentes dans une direction sensiblement perpendiculaire à l'épaisseur du substrat.

La région semiconductrice continue peut comprendre par exemple des couches successives dudit alliage s'étendant toutes au moins partiellement parallèlement à l'épaisseur du substrat et présentant respectivement des compositions différentes dudit alliage.

Les compositions différentes desdites zones ou couches peuvent former un gradient de concentrations de l'un des composants dudit alliage.

Ledit alliage peut comprendre du silicium et du germanium.

Selon un mode de réalisation, la face supérieure de ladite région continue peut comporter un profil en pente par rapport à la face supérieure du substrat.

La face supérieure de ladite région continue peut comporter par exemple un profil convexe ou concave.

D'autres avantages et caractéristiques de l'invention apparaîtront à la lecture de la description détaillée, donnée uniquement à titre d'exemple non limitatif et faite en référence aux dessins annexés sur lesquels :
- les figures 1 et 2 illustrent schématiquement des étapes d'un mode de mise en oeuvre permettant d'obtenir un gradient horizontal ;
- les figures 3 et 4 illustrent schématiquement des exemples de gravure en pente ;
- les figures 5 à 7 illustrent schématiquement des étapes d'un autre mode de mise en oeuvre permettant d'obtenir un gradient horizontal ; et
- les figures 8 et 9 illustrent schématiquement des exemples d'un autre mode de réalisation de la gravure en pente.

Bien que l'invention ne soit pas limitée à une telle combinaison de matériaux, on va décrire un mode de réalisation utilisant un substrat de silicium avec un alliage de silicium et de germanium.

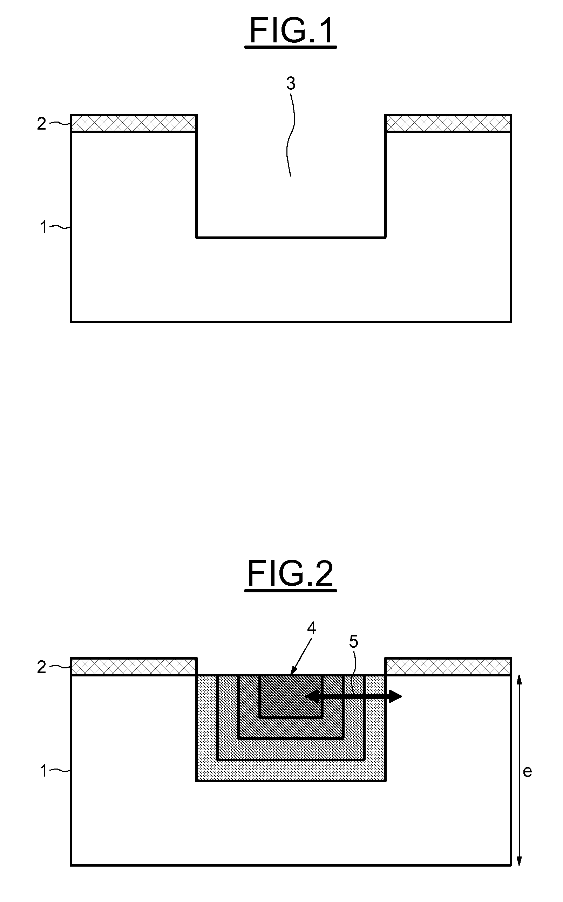

Sur la figure 1, on dépose une couche de protection 2 sur le substrat 1 de silicium afin de le protéger lors de la gravure de la cavité 3. Cette couche de protection 2 peut être déposée et mise en forme par lithographie de façon classique et connue en soi. La couche de protection 2 peut être par exemple une couche de nitrure de silicium SiNₓ ou d'oxyde de silicium SiO₂. La couche de protection peut également être une couche de résine déposée en couche épaisse.

Des couches successives 4 d'un alliage de silicium et de germanium sont déposées dans la cavité 3 (figure 2). Ces couches sont préférentiellement déposées de façon conforme de façon à épouser le relief de la cavité 3. Afin d'obtenir un gradient, les concentrations de silicium et de germanium des couches déposées sont modifiées d'une couche à la suivante. Par exemple, on peut faire varier la fraction x de germanium d'une couche à la suivante, x étant compris entre 0 et 0,2. On obtient bien un gradient horizontal s'étendant dans la direction 5 perpendiculairement à l'épaisseur e du substrat. La nature de ce gradient dépend de la façon dont x varie par rapport à l'épaisseur des couches. On pourra ainsi obtenir, par exemple et de façon non limitative, un gradient linéaire, exponentiel, parabolique ou hyperbolique. De plus, ce gradient peut présenter une direction horizontale ou une direction oblique suivant le rapport de forme donné à la cavité 3.

Un exemple d'application d'un tel gradient est l'obtention d'un profil en pente, par exemple convexe ou concave en utilisant une gravure sensible à la concentration de silicium ou de germanium.

Les procédés de gravure présentant un caractère chimique utilisent un réactif de gravure s'attaquant à une espèce du matériau à graver. Si la concentration de cette espèce varie dans le matériau, la vitesse de gravure varie également. On obtient ainsi une différence de vitesse de gravure sur la longueur du gradient. Cette variation de la vitesse de gravure permet de générer un profil non plan contrôlé par les conditions de gravure et par le gradient de concentration.

Pour graver localement les couches d'alliage 4, on peut utiliser par exemple, une gravure humide, une gravure sèche, un polissage mécano-chimique, une oxydation, une gravure haute température sous HCl ou une combinaison de tout ou partie de ces méthodes. Cela étant dans l'exemple de la figure 2, une gravure sensible à la concentration de Ge est issue d'une chimie à base de composés d'halogénures, en particulier les composés fluorés et/ou chlorés. L'homme du métier pourra aussi, à toutes fins utiles, se reporter à l'article paru dans la revue Microelectronic Engineering Volume 73-74, Issue 1 (Juin 2004) Pages 301 - 305.

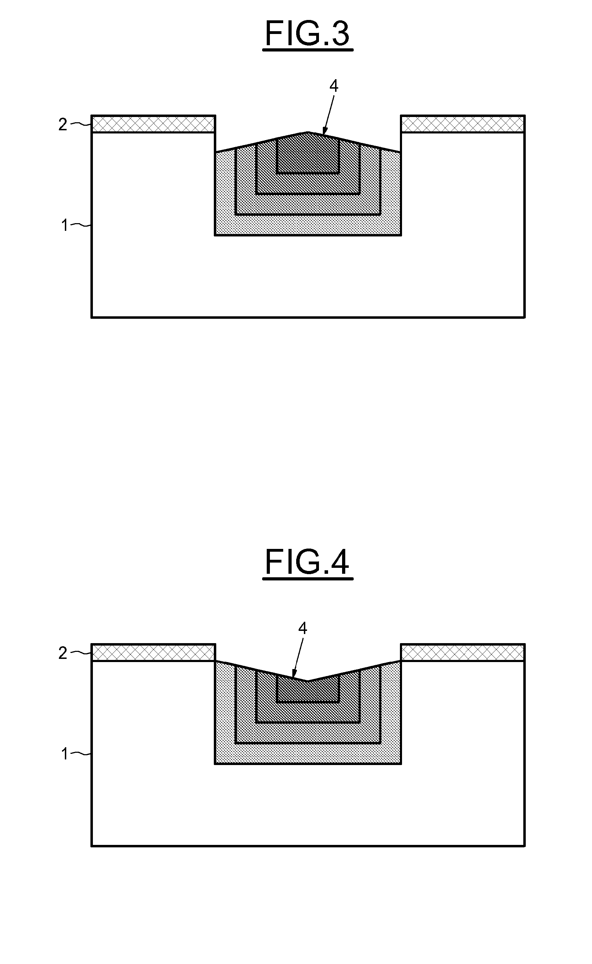

Sur la figure 2, la concentration maximale de germanium, correspondant à du SiGe, se situe, par exemple, au centre de la cavité 3 remplie par les couches successives 4. La concentration en germanium décroit d'une couche à la suivante jusqu'au silicium du substrat 1. Suivant le procédé de gravure deux résultats illustrés par les figures 3 et 4 sont envisageables. Ces deux résultats dépendent du procédé de gravure choisi.

Si la vitesse de gravure diminue avec une fraction croissante de Ge dans l'alliage SiGe, la partie présentant une forte concentration sera gravée plus lentement que la partie présentant une plus faible concentration. On obtient alors la figure 3.

Si la vitesse de gravure augmente avec une fraction croissante de Ge dans l'alliage SiGe, la partie présentant une forte concentration sera plus rapidement gravée que la partie présentant une faible concentration. On obtient alors la figure 4.

Dans les deux cas, on obtient bien un profil de gravure non plan.

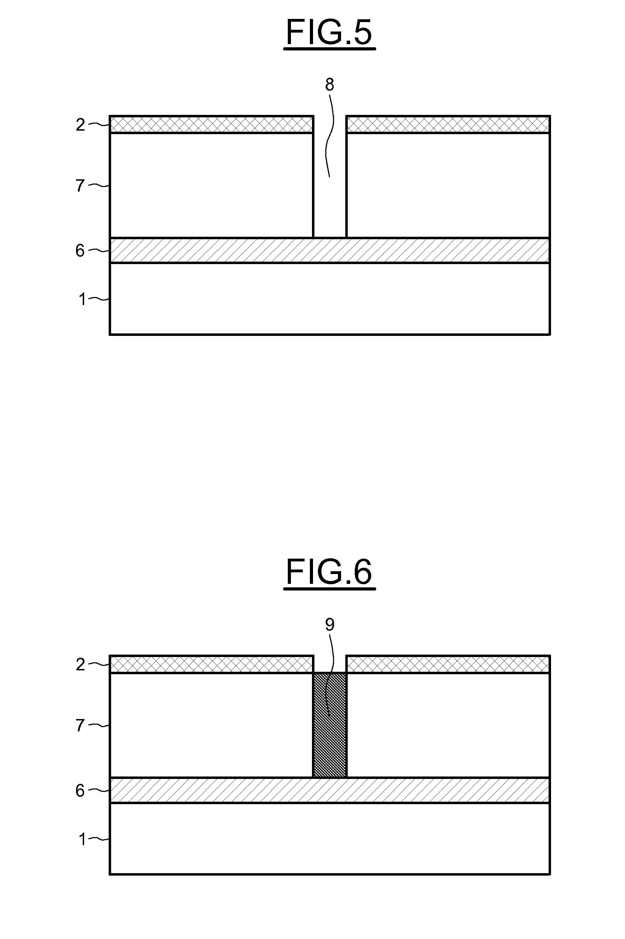

La figure 5 montre un autre mode de réalisation. Sur un substrat 1 de silicium, on réalise le dépôt d'une couche d'arrêt de gravure 6. Une couche d'arrêt de gravure présente des propriétés similaires à une couche de protection. On dépose ensuite une couche 7 de silicium, suivie d'une couche de protection 2 apte à protéger la couche 7 de silicium lors de la gravure de la cavité 8. Une alternative pourrait être de déposer une couche 7 d'un matériau différent du matériau du substrat 1.

Comme on peut le voir sur la figure 6, la cavité 8 est remplie par du SiGe à forte concentration en germanium, par exemple comprise entre 50 et 100% de Ge afin d'obtenir la structure 9. On peut utiliser un dépôt sélectif bien connu en soi.

On procède ensuite à un recuit thermique qui permet de stimuler la diffusion latérale du germanium de la structure 9 dans le silicium de la couche 7. Etant limité en surface par la couche de protection 2 et en profondeur par la couche d'arrêt de gravure 6, la diffusion thermique du germanium de la structure 9 s'effectue latéralement. Les mécanismes de contrôle et la cinétique de réaction font partie des connaissances de l'homme du métier. Dans le cas de la diffusion du germanium dans le silicium, la température de recuit thermique est comprise entre 900°C et 1100°C pour un alliage de SiGe présentant une concentration de Ge de 50%. D'une façon générale, la température de recuit thermique est limitée par la température de fusion de l'alliage le plus riche en Ge. Ici encore, la direction 5 symbolise le gradient horizontal de concentration obtenu.

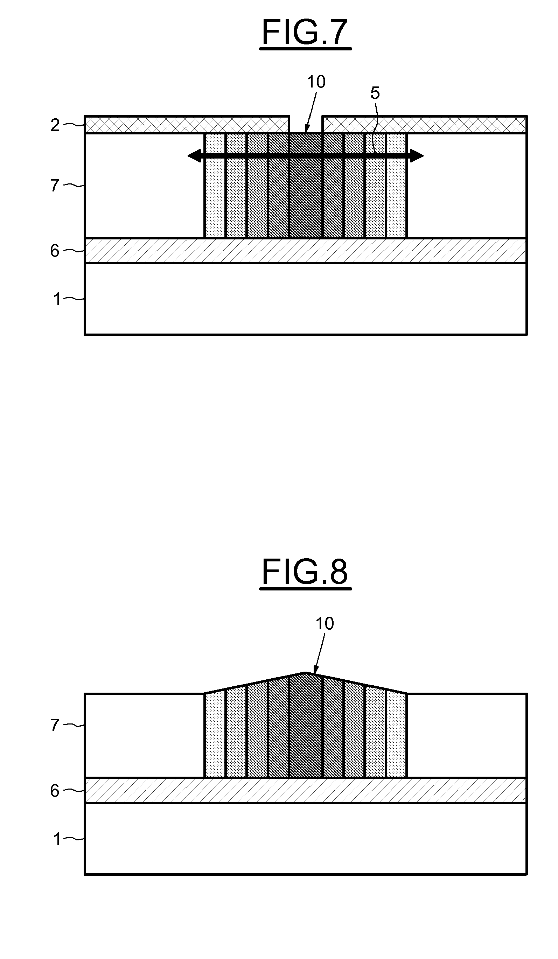

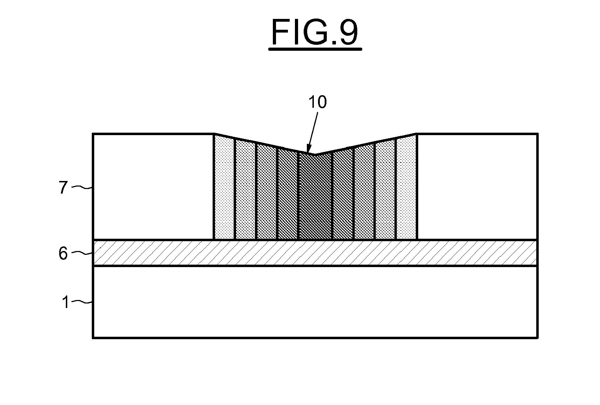

Ici encore, le dispositif peut être utilisé directement ou subir une gravure après retrait de la couche 2. Le raisonnement est analogue à celui menant à l'obtention des figures 3 et 4. Si la vitesse de gravure augmente avec une fraction croissante de Ge, on obtient le profil de gravure de la figure 9. Si le rapport des vitesses de gravure est inversé, on obtient le profil de la figure 8.

Ce qui vient d'être décrit ici peut s'appliquer à différents couples de matériaux, par exemple Si, SiOₓ, métaux, As,Ga, etc...

Parmi les nombreuses applications possibles du procédé, on peut citer ce qui suit, à titre d'exemple non limitatif.

Un tel résultat peut être utilisé tel quel, par exemple pour la réalisation de dispositifs selon un géométrie différente de celle que l'on peut normalement obtenir en microélectronique. Un exemple pourrait être un capteur dont la partie active serait constituée d'une succession de couches perpendiculaires au plan du substrat. Les différentes couches seraient facilement accessibles et connectables en surface.

Une autre application pourrait être la réalisation de régions dissymétriques de source et de drain de transistors MOS, dissymétriques par exemple en composition, en dopage ou en hauteur de barrière.

La différence de vitesse de gravure dans un gradient de concentration latéral entraînera une gravure en pente, qui, maîtrisée, conduit à la formation de surfaces vicinales pour la croissance ultérieure d'autres matériaux (polaires, piezo..). Par exemple, la croissance de GaAs sur du Ge requiert une orientation comprise entre 3 et 6° par rapport à un plan (100) de Ge, de même avec la croissance de GaN sur un plan de Si (100). Sans l'utilisation de gradients de concentration, il faut utiliser des substrats massifs, d'orientation non standard et donc coûteux.

La différence de vitesse de gravure dans un gradient de concentration latéral permet aussi, lorsque le gradient est enterré, de graver plus vite une partie centrale qu'une partie périphérique, donc de pouvoir soit compenser des difficultés de gravure dans des rapport de forme élevés, soit obtenir directement des profils de gravure inversés.

## Revendications

1. Procédé de fabrication d'un dispositif semiconducteur, **caractérisé par le fait qu'**il comprend la formation au sein d'un substrat semiconducteur (1) d'au moins une région continue (4) formée d'un matériau présentant une composition non uniforme dans une direction sensiblement perpendiculaire à l'épaisseur du substrat (1).

2. Procédé selon la revendication 1, dans lequel ladite région continue (4) est formée d'un matériau présentant une variation graduelle de composition le long de ladite direction.

3. Procédé selon la revendication 1 ou 2, dans lequel la formation de la région continue (4) comprend la formation de zones d'un alliage semi-conducteur ayant des compositions différentes dans une direction sensiblement perpendiculaire à l'épaisseur du substrat (1).

4. Procédé selon la revendication 3, dans lequel la formation desdites zones d'alliage comprend la formation de couches successives dudit alliage s'étendant toutes au moins partiellement dans une direction sensiblement parallèle à l'épaisseur du substrat (1) et présentant respectivement des compositions différentes dudit alliage.

5. Procédé selon la revendication 4, dans lequel les compositions différentes desdites couches forment un gradient de concentrations de l'un des composants dudit alliage.

6. Procédé selon l'une des revendications 3 à 5, dans lequel ledit alliage comprend du silicium et du germanium.

7. Procédé selon l'une des revendications 3 à 6, dans lequel la formation de la région semiconductrice continue (4) comprend la formation d'une cavité (3) dans le substrat et la formation au moins sur les parois verticales de la cavité (3) d'un empilement de couches dudit alliage présentant respectivement des compositions différentes dudit alliage.

8. Procédé selon l'une des revendications 3 à 6, dans lequel le substrat (1) est formé d'un des composants dudit alliage et la formation de la région semiconductrice continue (9) comprend la formation d'une cavité (8) dans le substrat (1), le remplissage de la cavité (8) par ledit alliage et un recuit de diffusion de façon à former dans une partie (7) du substrat adjacente à ladite cavité (8), des couches successives (10) dudit alliage s'étendant toutes dans une direction sensiblement parallèle à l'épaisseur du substrat (1) et présentant respectivement des compositions différentes dudit alliage.

9. Procédé selon l'une des revendications précédentes, comprenant en outre une gravure de la surface supérieure de ladite région continue (4 ou 10), ladite gravure ayant des caractéristiques différentes en fonction de ladite composition.

10. Dispositif semiconducteur, **caractérisé par le fait qu'**il comprend au sein d'un substrat semiconducteur (1) au moins une région continue (4) formée d'un matériau présentant une composition non uniforme dans une direction sensiblement perpendiculaire à l'épaisseur du substrat.

11. Dispositif selon la revendication 10, dans lequel ladite région continue (4) est formée d'un matériau présentant une variation graduelle de composition le long de ladite direction.

12. Dispositif selon la revendication 10 ou 11, dans lequel la région semiconductrice continue (4) comprend un alliage semi-conducteur ayant des zones de compositions différentes dans une direction sensiblement perpendiculaire à l'épaisseur du substrat (1).

13. Dispositif selon la revendication 12, dans lequel la région semiconductrice continue (4) comprend des couches successives dudit alliage s'étendant toutes au moins partiellement parallèlement à l'épaisseur du substrat et présentant respectivement des compositions différentes dudit alliage.

14. Dispositif selon la revendication 12 ou 13, dans lequel les compositions différentes desdites zones ou couches forment un gradient de concentrations de l'un des composants dudit alliage.

15. Dispositif selon l'une des revendications 12 à 14, dans lequel ledit alliage comprend du silicium et du germanium.

16. Dispositif selon l'une des revendications 10 à 15, dans lequel la face supérieure de ladite région continue (4) comporte un profil en pente par rapport à la face supérieure du substrat (1).

17. Dispositif selon la revendication 16, dans lequel la face supérieure de ladite région continue (4) comporte un profil convexe ou concave.
